# EUROPÄISCHE PATENTSCHRIFT

(11) **EP 1 381 579 B1**
(45) Veröffentlichungstag und Bekanntmachung des Hinweises auf die Patenterteilung: **05.06.2013**
(21) Anmeldenummer: 02722167.0
(22) Anmeldetag: 02.03.2002
(51) Int. Cl.: F28F 21/04, H01G 4/30

(54) **VERFAHREN ZUR VERBINDUNG KERAMISCHER GRÜNKÖRPER UNTER VERWENDUNG EINES TRANSFERTAPES UND ÜBERFÜHRUNG DIESER VERKLEBTEN GRÜNKÖRPER IN EINEN KERAMIKKÖRPER**
METHOD FOR JOINING CERAMIC GREEN BODIES USING A TRANSFER TAPE AND CONVERSION OF BONDED GREEN BODY INTO A CERAMIC BODY
PROCEDE POUR LIER DES CORPS CRUS EN CERAMIQUE AU MOYEN D'UNE BANDE DE TRANSFERT ET TRANSFORMATION DE CES CORPS CRUS LIES EN UN CORPS EN CERAMIQUE

(30) Priorität: 20.03.2001 DE 10113361
(43) Veröffentlichungstag der Anmeldung: 21.01.2004
(73) Patentinhaber: TESA SE, 20253 Hamburg (DE); Roosen, Andreas, 91054 Erlangen (DE)
(72) Erfinder: SCHRÖDER, Andreas, 22547 Hamburg (DE); ZÖLLNER, Stephan, 21244 Buchholz /Nordheide (DE); ROOSEN, Andreas, 91054 Erlangen (DE)
(86) Internationale Anmeldenummer: PCT/EP2002/002263
(87) Internationale Veröffentlichungsnummer: WO 2002/074715

(56) Entgegenhaltungen:
- DE-A- 19 725 948
- PATENT ABSTRACTS OF JAPAN vol. 17, no. 533 (C-1114), 27. September 1993 (1993-09-27) & JP 05 148046 A (KIKUSUI KAGAKU KOGYO KK), 15. Juni 1993 (1993-06-15)

## Beschreibung

Die Erfindung betrifft ein Verfahren zur Herstellung einer stoffschlüssigen Verbindung zwischen keramischen Grünkörpern, so daß diese nach dem Sintem fest miteinander verbunden sind. Das Verfahren eignet sich insbesondere zum Laminieren von keramischen Grünfolien zur Herstellung von Funktions- und Ingenieurkeramiken wie zum Beispiel hochintegrierte Mehrlagenschaltungen, Gehäuse, Kondensatoren, Aktoren. Sensoren, HT-Brennstoffzellen, Wärmetauscher u.a. /88 Roo/, /96 Hel/.

Grundlage der keramischen Laminiertechnik sind keramische Grünfolien, die durch das Foliengießen hergestellt werden /88 Roo/, /96 Hel/. Die Grünfolien sind zwischen 10 µm und 2 mm stark und bestehen aus Keramikpulver, das in eine Polymermatrix, häufig auf Basis von Polyvinylbutyral (PVB), eingebettet ist. Zugefügte Weichmacher geben der Folie eine gewisse Flexibilität. Vor dem Laminieren können die einzelnen Lagen der zu laminierenden Grünfolien je nach Anwendung strukturiert werden, d.h., mit Durchführungen oder anderen Aussparungen bzw. Strukturen versehen und mit Metallpasten bedruckt werden.

Eine Möglichkeit der Lamination stellt das Thermokompressionsverfahren dar, wobei unter Druck und Temperatur laminiert wird. Bei diesem Verfahren werden die Folien gestapelt und dann unter Drücken zwischen 15 MPa /86 Boc/ und 100 MPa /95 Tuf/ bei Temperaturen zwischen 60 °C /86 Boc/ und ca. 110 °C /97 Cha/ verpreßt /94 Ree/. Die erhöhte Temperatur ist zur Erweichung des Binders (Polymers) nötig. Bei der Thermokompression unter isostatischen Bedingungen werden Drücke bis 400 MPa eingesetzt. Druck und Temperatur sind voneinander abhängig: Eine niedrige Temperatur erfordert einen höheren Druck; umgekehrt gilt das gleiche.

Es ist für einen guten, fehlerfreien Verbund wichtig /96 Hel/, daß sich beim Laminieren die Pulverteilchen in den sich berührenden Grünfolienoberflächen reorientieren und es zu einer Verzahnung der Pulverpartikel in den Kontaktflächen zwischen den Folien kommt. Die Triebkraft für die Umlagerung der Pulverkörner ist der von außen angelegte Druck in Verbindung mit der Erweichung des Polymers. Um eine Reorientierung zu ermöglichen, sind einige Anforderungen an die Grünfolie zu stellen. Die relativen Volumina der Poren, des Pulvers und des Binders müssen in einem bestimmten Verhältnis zueinander stehen /96 Hel/.

Die Nachteile dieses Thermokompressionsverfahrens sind
- der Zeitaufwand, da der Druck je nach Anzahl der Lagen für einige Zeit bei erhöhter Temperatur zum Erreichen des thermischen Gleichgewichts innerhalb der zu laminierenden Folien-Stapels gehalten werden muß.
   Damit ist von vornherein ein kontinuierlicher Prozeß ausgeschlossen.
- erhöhter Druck und Temperatur der Thermokompression, die zu einem Massefluß führen, der Verformungen der ursprünglichen Geometrie mit sich bringt.
   Deshalb muß zur Vermeidung der Verformung des Laminats in Länge, Breite und Dicke Formwerkzeuge (Matrizen) eingesetzt werden.

Bei der Herstellung von Hohlraumstrukturen über den schichtweisen Aufbau von strukturierten Laminaten (Wärmetauscher /87 Hei/) kommt es zu weiteren Problemen.
- Beim Aufbau von Schichtstrukturen werden zum Teil Aussparungen in die Grünfolien gestanzt. Durch Aufeinanderschichtung der einzelnen Lagen und deren Verbindung über Lamination entstehen dann zum Beispiel im Fall des Wärmetauschers Kanalsysteme. Bei Anwendung der Thermokompression entsteht durch die Kavitäten in den Grünfolien eine inhomogene Druckverteilung in Laminat mit teilweise ungenügendem Druckdurchgriff, die zu einer ungenügenden Lamination und damit zu unerwünschten Delaminationen führt, d.h., die Folienlagen wind nach dem Sintern nicht durchgängig miteinander verbunden, die Schädigungszonen führen zu Eigenschaftsänderungen, wodurch das Teil Ausschuß darstellt.
- Besonders problematisch ist es, feine Strukturen, beispielsweise Waben oder sehr feine Leiterbahnstrukturen im Laminat zu realisieren, da diese durch den aufgebrachten Druck und Temperatur durch den damit verbundenen Massefluß zerstört werden.
- Die Methode benötigt bestimmte Gefüge der Grünfolien hinsichtlich des Verhältnisses von Poren, Pulver und Binder zueinander.
- Auf Binder, die bei Folien auf Wasserbasis zum Einsatz kommen, spricht die Thermokompression weniger gut an als auf Folien, die aus Schlickern auf Basis von organischen Lösemitteln hergestellt wurden.

Im Rahmen des Thermokompressionsverfahrens ist bisher versucht worden, diese Probleme mit Laminierhilfen zu überwinden, die im wesentlichen Lösemittel und Binder enthalten. Sie haben die Funktion, die Grünfolien oberflächlich anzulösen, so daß mit geringeren Drücken und Temperaturen gearbeitet werden kann. Nachteil ist, daß die Auftragung der Laminierhilfe einen zusätzlichen Arbeitsschritt erfordert und daß durch das Anlösen des Binders das Laminat leichter verformt werden kann. Die o.g. Temperatur- und Druckbereiche beziehen sich auch auf den Einsatz von Laminierhilfen.

Dieses Problem wurde mit der Einführung des sogenannten "Kalt-Niederdruck-Laminationsverfahren" behoben, wie es in der DE 197 25 948 A1 offenbart ist, (siehe auch /99 Piw/). Bei diesem Verfahren werden die unbedruckten oder bedruckten Grünfolien unter Verwendung eines Doppelklebebandes (beidseitig klebend) miteinander bei Raumtemperatur unter leichtem Druck (Handdruck) miteinander verklebt. Der Trägerfilm erlaubt das Fügen der Grünfolien zu dichtgesinterten Körpern, ohne daß beim Laminieren eine Verzahnung der Partikel (siehe Thermokompression: Druck und Temperatur) vorliegt.

Im Gegensatz dazu sind im Falle der Kalt-Niederdruck-Lamination die Grünfolie nach dem Verkleben durch einen polymeren Trägerfilm voneinander getrennt. Dieser Trägerfilm ist dafür verantwortlich, daß es im weiteren Ausheiz- und Sinterverlauf trotzdem zu einem Verbund der beiden Folien kommt. Der Film wird bei höheren Temperaturen zu einer dünnflüssigen Schmelze. Die Schmelze wird durch die Kapillarität des keramischen Körpers (Porenstruktur), in dem die anderen organischen Hilfsstoffe bereits weitestgehend ausgeheizt sind, in die Porengänge gesogen. Die dabei auftretenden Kapillarkräfte ziehen die beiden Körper aneinander. In der flüssigen Polymerschmelze können sich die keramischen Pulverteilchen ineinanderschieben, es kommt zu der geforderten Verzahnung. Dazu müssen die keramischen Pulverteilchen frei beweglich sein, also die organischen Additive, die in der Grünfolie enthalten sind, weitestgehend ausgetrieben sein, und es darf noch keine Halsbildung beim Sintern aufgetreten sein, die ebenfalls die Beweglichkeit herabsetzen würde.

Bei diesem Verfahren wird der nötige Druck zum Verzahnen der einzelnen keramischen Folienlagen nicht von außen durch Pressen bei gleichzeitig erhöhter Temperatur aufgebracht, sondern zwischen den Lagen durch die Kapillarkräfte erzeugt, die durch die Ausbildung der Polymerschmelze entstehen, also im Grünkörpergefüge, d.h. in situ.

Die Vorteile des Verfahrens liegen auf der Hand:
- Die Lamination erfolgt bei Raumtemperatur und sehr geringen Drücken. Dieses ist zeit- und energiesparend, da das Aufheizen und Halten bei einer erhöhten Temperatur entfällt.
- Dadurch entfällt gegenüber der Thermokompression die Wartezeit zum Ausgleich einer erhöhten Temperatur. Dadurch ist eine kontinuierliche Fertigung von Laminaten möglich. Sowohl die Grünfolie, als auch das Doppelklebeband können von Rollen abgezogen werden.
- Bei Raumtemperatur ist der Binder der Grünfolie noch nicht erweicht, so daß das Laminieren ohne Formwerkzeug durchgeführt werden kann. Dadurch können Werkzeugkosten eingespart werden.
- Da der Binder nicht erweicht, tritt auch kein Massefluß auf. Dadurch lassen sich auch komplizierte, dreidimensionale Hohlraumstrukturen realisieren.
- Da der Druck zum Verzahnen der Folienlagen durch Kapillarkräfte erzeugt wird, liegt er überall im Laminat gleich verteilt vor und dies auch in komplexen Strukturen mit Hohlräumen oder sehr feinen Leiterbahnen. Deshalb entstehen keine Delaminationen oder Nahtstellen im Material.
- Das Verfahren funktioniert auch im Falle von Folien, die auf Wasserbasis hergestellt wurden.
- Darüber hinaus lassen sich mit dieser Methode auch andere keramische Grünkörper miteinander verbinden.

Nachteil des Verfahrens mit dem Einsatz von doppelseitigen Klebebändern ist die Dicke des doppelklebenden Bandes und damit die Materialmenge, die in dem keramischen Ausheizprozeß ausgebrannt werden muß. Dabei hat der Kleber nur die Funktion des Klebens, während der Trägerfilm eine Polymerschmelze bilden muß, die für den einwandfreien Resultat der verklebten Folien ausschlaggebend ist. In dem Prozeß muß zunächst der Kleber ausgebrannt werden, bevor aus der Trägerfolie die Polymerschmelze entsteht.

Dieses Verfahren wird verbessert, in dem das doppelte Klebeband durch eine aufdruckbare Klebemasse ersetzt wird. Der flüssige Kleber kann durch ein Siebdruckverfahren auf die zu verbindenden Folien gebracht werden, wobei Siebdruckverfahren in der keramischen Folientechnologie zur Metallisierung bereits prozeßintegriert sind. Bei dem Verfahren kann die Viskosität des Klebers in gewissen Grenzen angepaßt werden.

Nachteil des Verfahrens für siebdruckfähige Kleber ist die Erzeugung einer klebenden Schicht, die extrem staubempfindlich ist. In der Keramik müssen derartige Staubpartikel von den Funktionsflächen der Grünfolien ferngehalten werden, da diese die kleinen Strukturen zerstören und zu Fehlstellen (Poren) in der gesinterten Keramik führen, was die Festigkeit drastisch herabsetzt (Keramik ist ein spröder Werkstoff). Damit muß eine mit Kleber siebbedruckte Folie direkt weiterverarbeitet werden, d.h., eine in Fertigungen häufig erwünschte Zwischenlagerung, die auch ein Stapeln beinhaltet, ist nicht möglich. Ferner erfordert der Siebdruck von Klebern einen Trockenschritt, um das in deutlichen Mengen eingesetzte Lösemittel wieder auszutreiben. Ferner führt der Auftrag von Lösemitteln auf die Folien zu einem Quellen der Grünfolien, das schon beim Siebdruck der Metallisierungen als ungünstig bewertet wird.

Aus dem Abstract zur JP 05 148 046 A1, ist ein Klebefilm bekannt, der mit anorganischen Füllstoffen wie Oxiden (Siliziumoxid, Aluminiumoxid und Zirkoniumoxid) als Hauptkomponenten gefüllt ist. Der Klebstoff ist eine synthetische Harzemulsion, die mit den Oxiden, Wasser und einem Emulgator gemischt auf einen Liner beschichtet werden kann. Erhalten wird so ein gefüllter Klebefilm.

### Literatur:

| | |
|---|---|
| /86 Boc/ | P. Boch, C.Chartier, M. Huttepain,"Tape Casting of Al2O3/ZrO2 Laminated Composites", J. Am. Ceram. Soc. 69 [8] (1986) C191-C192 |
| /87 Hei/ | J. Heinrich, J. Huber, H. Schelter, R. Ganz, R. Golly, S. Foerster, P. Quell, "Compact Ceramic Heat-Exchangers: Design, Fabrication and Testing", Brit.Ceram.Trans.J. 86 [6] (1987) 178-182 |
| /88 Roo/ | A. Roosen, Basic requirements for tape casting of ceramic powders, in Ceram. Transactions, Vol. 1, Part B, Ceramic Powder Science, Am. Ceram. Soc., Inc., Columbus, OH, 1988, pp. 675-692 |
| /89 Cim/ | M.J. Cima, M. Dudziak, J.A. Lewis, "Observation of Poly(vinyl Butyral) Dibutyl Phthalate Binder Capillary Migration", J.Am.Ceram.Soc., 72 [6] (1989), 1087-1090 |
| /94 Ree/ | J.S. Reed, Principles of Ceramics Processing, 2nd Ed., John Wiley & Sons, New York, 1994 |
| /95 Tuf/ | S. Tuffé, D.S. Wilkinson, "MoSi2-Based Sandwich Composite Made by Tape-Casting", J.Am.Ceram.Soc., 78 [11] (1995), 2967-2972 |
| /96 Hel/ | H.Hellebrand, "Tape Casting"; pp 189-265 in Materials Science and Technology, Vol.17 A, Processing of ceramics,Part 1, ed R.J. Brook, VCH Verlagsgesellschaft, Weinheim, FRG 1996 |
| /97 Cha/ | T. Chartier T. Rouxel, "Tape-Cast Alumina-Zirconia Laminates: Processing and Mechanical Properties", J.Eur.Ceram.Soc.17 [2-3] (1997), 299-308 |
| /99 Piw/ | M. Piwonski, A. Roosen, Low Pressure Lamination of Ceramic Green Tapes by Gluing at Room Temperature. J. Europ. Ceram. Soc. 1999, 19, 263-270 |

Die Aufgabe der Erfindung ist es, einen keramischen Grünkörper zur Verfügung zu stellen, der aus einer weiteren verfahrenstechnischen Vereinfachung der Kalt-Niederdruck-Lamination stammt, um somit die Nachteile des Standes der Technik zu beheben.

Gelöst wird diese Aufgabe durch ein Verfahren zur Herstellung eines keramischen Grünkörpers, wie es im Hauptanspruch niedergelegt ist. Gegenstand der Unteransprüche sind dabei vorteilhafte Weiterbildungen des Verfahrens, schließlich noch Verwendungsvorschläge für die keramischen Grünkörper.

Eine elegantere Methode als die Verwendung von doppelseitigen Klebebändern oder von Siebdruckpasten ist die Verwendung eines Klebebands, das aus einem auf einem Releaseliner aufgebrachten Klebefilm besteht, ein sogenanntes Transfertape.

Das doppelseitige Klebeband besteht aus zwei Klebschichten, die auf einem Träger aufgebracht sind und mit Abdeckfolien zum Schutz der Klebeschichten versehen sind, die vor dem Verkleben abgezogen werden. Beim Kalt-Niederdruckverfahren dient die Klebeschichten zur Fixierung und vorübergehenden Verbindung der miteinander zu laminierenden keramischen Grünkörper. Der innengelegene Trägerfilm dient im späteren Verlauf des Ausheizens der organischen Bestandteile zur Bildung einer flüssigen Phase, die Kapillarkräfte verursacht (s.o.). Durch diesen mehrschichtigen Aufbau ist das Klebeband relativ dick.

Ein viel einfacherer Aufbau ergibt sich, wenn man ein Transfertape verwendet. Dieses Klebeband besteht aus einem Klebefilm, der sich auf einem Releaseliner befindet, der den Klebefilm im Sinne einer Abdeckfolie schützt. Dieser Klebefilm wird auf einen der zu verklebenden Grünkörper aufgebracht und der Liner kann jederzeit vor Verwendung abgezogen werden. Damit befindet sich zwischen den beiden keramischen Grünkörpern nur noch ein Klebefilm.

Dieser monolithische Klebefilm vereint die zwei Anforderungen, die das doppelseitige Klebeband mit seinen drei Schichten erfüllt, in einer Schicht.
- Er verklebt die miteinander zu verbindenden Folien bei Temperaturen < 100 °C und
- er bildet eine flüssige Phase bei erhöhten Temperaturen zur Ausbildung von Kapillarkräften.

Dies wird im Folgenden näher erläutert:
Dieser Klebefilm (Transferfilm) sollte bestimmte Anforderungen erfüllen. Bei Verwendungstemperatur sollte er haftklebrig sein, damit er auf die Grünfolie übertragen werden kann. Dies kann durch Umkaschieren an einem Laminator oder anderem üblich verwendetem Equipment geschehen. In einigen Fällen kann es besonders günstig sein, wenn Wärme und leichter Druck für diesen Vorgang angewendet wird.

Der Klebefilm ist einer bevorzugten Ausführungsform besonders dünn, damit nicht zuviel überflüssiges Material beim Binderausbrand bzw. Sintervorgang ausgetrieben werden muß. Der Klebefilm weist eine Schichtdicke auf von 2 bis 50 µm, besonders bevorzugt 5 bis 25 µm.

Ein ganz besonders günstiges Laminierergebnis wird erhalten, wenn der Klebefilm oder das Klebeband orientiert ist. Ein in x-y Richtung vor der Verfestigung bzw. Vernetzung orientierter Klebefilm schrumpft bei Erwärmung, so daß neben der Ausbildung von Kapillarkräften eine zusätzliche Anziehung des Laminierguts die Folge ist.

Der Haftkleber muß so beschaffen sein, daß er bei höheren Temperaturen so stark verflüssigt, daß die Masseschmelze in die Keramikporen einfließen kann, damit sich notwendige Kapillarkräfte in den porösen Grünkörpern ausbilden. Ein günstiger Temperaturbereich ist 200 °C bis 600 °C, bevorzugt 250 °C und 550 °C. Erst danach wird der Kleber vollständig zersetzt.

Es wurde gefunden, daß insbesondere Copolymere von Acrylaten und Methacrylaten diesen Anforderungen genügen. Die Zusammensetzung der entsprechenden Comonomere wird so gewählt, daß die resultierenden Haftklebemassen entsprechend D. Satas [Handbook of Pressure Sensitive Adhesive Technology, 1989, Verlag VAN NOSTRAND REINHOLD, New York] haftklebende Eigenschaften besitzen.

Der Klebefilm besteht aus einer Mischung aus
a) Acrylsäure- und/oder Methacrylsäurederivate entsprechend der allgemeinen Formel

   CH₂=CH(R₁)(COOR₂)

   mit
   R₁ = H oder CH₃ und
   R₂ = eine verzweigte oder unverzweigte Alkylkette mit 2 bis 20 Kohlenstoffatomen, und
b) olefinisch ungesättigte Monomere mit funktionellen Gruppen.

Die Zusammensetzung der Haftklebemasse ist dabei derart gewählt, daß die Komponente a) mit einem Anteil von 70 bis 99 Gew.-%, insbesondere von 80 bis 99 Gew.-%, und/oder die Komponente b) mit einem Anteil von 1 bis 30 Gew.-%, insbesondere von 1 bis 20 Gew.-%, wobei die Summe dieser Komponenten und gegebenenfalls weiterer Komponenten oder Zusatzstoffe sich zu 100 Gew.-% addiert.

Zur Herstellung der Acrylathaftktebemasse wird eine radikalische Polymerisation durchgeführt. Die radikalische Polymerisation kann in Gegenwart eines organischen Lösungsmittels, in Wasser, in Mischungen aus organischen Lösungsmitteln oder aus organischen Lösungsmitteln und Wasser, oder in Substanz durchgeführt werden. Bevorzugt wird so wenig Lösungsmittel wie möglich eingesetzt. Die Polymerisationszeit beträgt -je nach Umsatz und Temperatur- zwischen 6 und 48 h.

Bei der Lösungsmittelpolymerisation werden als Lösemittel vorzugsweise Ester gesättigter Carbonsäuren (wie Ethylacetat), aliphatische Kohlenwasserstoffe (wie n-Hexan oder n-Heptan), Ketone (wie Aceton oder Methylethylketon), Siedegrenzbenzin oder Gemische dieser Lösungsmittel verwendet. Als Polymerisationsinitiatoren werden übliche radikalbildende Verbindungen, wie beispielsweise Peroxide und Azoverbindungen, eingesetzt. Auch Initiatorgemische können verwendet werden. Bei der Polymerisation ist es vorteilhaft, Thiole als weitere Regler zur Molekulargewichtssenkung und Verringerung der Polydispersität einzusetzen. Als sogenannte Polymerisationsregler können zum Beispiel Alkohole und Ether verwendet werden.

Die Polymerisation zur Herstellung der Acrylathaftklebemasse kann in Polymerisationsreaktoren durchgeführt werden, die im allgemeinen mit einem Rührer, mehreren Zulaufgefäßen, Rückflußkühler, Heizung und Kühlung versehen und für das Arbeiten unter N₂-Atmosphäre und Überdruck ausgerüstet sind.

Nach der Polymerisation in Lösung kann das Polymerisationsmedium unter vermindertem Druck entfernt werden, wobei dieser Vorgang bei erhöhten Temperaturen, beispielsweise im Bereich von 80 bis 150 °C durchgeführt wird. Die Polymere können dann in lösemittelfreiem Zustand, insbesondere als Schmelzhaftkleber, eingesetzt werden. In manchen Fällen ist es auch von Vorteil, die Polymere in Substanz herzustellen.

Für die Herstellung von Klebebändern kann die Haftklebemasse aus der Schmelze heraus weiterverarbeitet werden, wobei sie insbesondere auf einen Träger aufgetragen wird. Besonders vorteilhaft ist, wenn die Masse aus der Schmelze beschichtet wird. Denn dann kann die Schicht in x-y Richtung verschreckt werden. Eine so verstreckte Schicht, insbesondere wenn diese nach der Verstreckung vernetzt wird, kann durch Erwärmen zurückstellen. Diese Rückstellkraft führt zusätzlich zur Kapillarkraft zu einem besseren Laminierergebnis. So können auch feinporige Grünfolien laminiert werden.

Besonders vorteilhaft lassen sich die keramischen Grünkörper zur Sinterung von Keramiken verwenden.

Dabei wird der keramische Grünkörper in einer bevorzugten Variante nach dem Verkleben mindestens einer Temperaturbehandlung unterzogen, wobei zunächst die Polymermatrix der Grünfolien zumindest weitgehend thermisch zersetzt und/oder verdunstet wird, anschließend das Transfertape zersetzt wird und wobei anschließend der Grünkörper zu dem eigentlichen keramischen Produkt gesintert wird.

Vorzugsweise erfolgt das Sintern bei Temperaturen von 700 °C bis 2000 °C.

Die Vorteile des erfindungsgemäßen Verfahrens sind:
- Es ist die Übertragung des dreischichtigen Aufbaus des doppelseitigen Klebebandes mit seinen zwei verschiedenen Materialien in einen Klebefilm aus einem Material gelungen. Dieses Material erfüllt die beiden notwendigen Funktionen: Kleben und Ausbildung einer Polymerschmelze.
- Da die Transfertapes dünner als die doppelseitigen Klebebänder sind, sinkt damit die Menge der während der gesamten thermischen Behandlung der Keramik (Ausbrand und Sintern) auszutreibenden Organik, was zu erheblichen Vorteilen bei der Ausheizgeschwindigkeit führt und die Gefahr von Schädigungen verringert.
- Des weiteren ist der Kleber anders als Flüssigkleber von der Rolle verarbeitbar. Damit ist auf einfache Weise eine Möglichkeit zur kontinuierlichen Produktion von Laminaten gegeben. Sowohl die Grünfolie, als auch das Transferklebeband können von Rollen abgezogen werden. Über Walzen können zunächst die einzelnen Grünfolienbahnen mit Klebeband beklebt werden. Nach Abziehen des Silikonpapiers vom Transfertape können dann die einzelnen Lagen über Andruckwalzen verbunden werden. Es entsteht ein endloses Laminat, welches durch Stanzen in kleine Einheiten geteilt werden kann. Dadurch werden hohe Stückzahlen möglich, was die Effizienz steigert und die Stückkosten senkt.
- Die Folien können vor dem Freisetzen der Klebeschicht zur Zwischenlagerung gestapelt und gelagert werden.
- Es ist kein Trockenschritt erforderlich, da das Transfertape nicht flüssig aufgebracht wird.
- Da das Transfertape kein Lösemittel enthält, kann dieses auch nicht in die Grünfolie eindringen. Dadurch tritt kein Aufquellen (Formveränderung) der Folie auf.
- Das Transfertape ist stark verformbar und kann sich damit an Unebenheiten anpassen und nivelliert damit ähnlich wie Flüssigkleber metallisierte Bereiche. Das Tape ist verformbar, da es keinen starren Film wie die doppelseitigen Klebebänder enthält.
- Das Verfahren weist als Kalt-Niederdruckverfahren alle Vorteile dieses Verfahrens auf, wie sie bereits geschildert worden sind.

Die Funktionsweise dieser Transfertapes basiert darauf, daß sie bei höheren Temperaturen in eine dünnflüssige Schmelze übergehen. Die Schmelze wird durch die Kapillarität des keramischen Körpers, in dem die anderen organischen Hilfsstoffe bereits weitestgehend ausgeheizt sind, in die Porengänge gesogen. Die dabei auftretenden Kapillarkräfte ziehen die beiden Körper aneinander. In der flüssigen Polymerschmelze können sich die keramischen Pulverteilchen ineinanderschieben, es kommt zu der geforderten Verzahnung. Dazu müssen die keramischen Pulverteilchen frei beweglich sein. Dazu müssen die organischen Additive, die in der Grünfolie enthalten sind, weitestgehend ausgetrieben sein und es darf noch keine Halsbildung beim Sintern aufgetreten sein, die ebenfalls die Beweglichkeit herabsetzen würde.

Das hier anhand von keramischen Grünfolien demonstrierte Verfahren kann allgemein zur Verbindung von keramischen Grünkörpern oder vorgesinterten Körpern mit einer ausreichenden Restporosität angewandt werden.

Das Verfahren besteht aus zwei wesentlichen Schritten:
1. dem Aufbringen des Transferklebebandes sowie das Verkleben der zu verbindenden Körper und
2. der Temperaturbehandlung zum Austreiben der Binder und des Transferklebebandes sowie das anschließende Dichtsintern der Körper.

Vorzugsweise wird also zur Herstellung eines keramischen Körpers zunächst auf einen ersten keramischen Grünkörper zumindest bereichsweise und zumindest einseitig ein Klebeband aufgeklebt, das aus einem auf einem Releaseliner befindlichen Klebefilm besteht. Dann wird der Releaseliner entfernt, abschließend der erste keramische Grünkörper mit dem zweiten keramischen verklebt.

Bei den Grünkörpern handelt es sich in einer hervorragend ausgestalteten Ausführungsform der Erfindung um Grünfolien, vorzugsweise um mindestens zwei miteinander verklebte, keramische Grünfolien, wobei die Grünfolien unmetallisiert oder metallisiert sein können.

Weiter vorzugsweise werden die Grünkörper nach Aufbringen des Klebebandes und Abziehen des Releaseliners durch insbesondere leichten Andruck miteinander verklebt, im Falle von Grünfolien als keramischen Grünkörpern geschieht dies im aufeinander gestapelten Zustand.

Im folgenden soll die Erfindung anhand eines Beispiels sowie einer Figur näher erläutert werden, ohne damit die Erfindung unnötig einschränken zu wollen.

Das erfindungsgemäße Verfahren beruht auf dem Verkleben der Grünfolienlagen mit einem geeigneten Transferklebeband bei Raumtemperatur. Dieses Transfertape besteht aus einer 30 µm dicken Schicht einer Acrylathaftklebemasse auf einem beidseitig silikonisierten Releaseliner. Die Gesamtdicke des Transfertapes beträgt 100 µm. Das Transfertape kann in Lappenform oder aufgewickelt in Form von Rollen vorliegen. Der Releaseliner erlaubt das Aufbringen und Andrücken des Transferklebebandes auf die Grünfolie. Vor dem Verbinden mit einer weiteren Grünfolienlage muß das Silikonpapier abgezogen werden.

Die Acrylathaftklebemasse ist ein Copolymer aus 98 Gew.-% 2-Ethylhexylacrylat und 2 Gew.-% Acrylsäure (M_{w}: 820.000, D: 4.2), das konventionell über eine freie radikalische Polymerisation in Lösung (Aceton/Siedegrenzenbenzin 1:1) hergestellt worden ist.

### Polymerisation/Transfertapeherstellung

Ein für radikalische Polymerisationen konventioneller 2 L-Glasreaktor wurde mit 8 g Acrylsäure, 392 g 2-Ethylhexylacrylat, 266 g Aceton/Benzin 60.95 (1:1) und 8 g Isopropanol befüllt. Nachdem 45 Minuten Stickstoffgas unter Rühren durch die Reaktionslösung geleitet worden war, wurde der Reaktor auf 58 °C geheizt und 0,2 g AIBN [2,2'-Azobis(2-methylbutyronitril)] hinzugegeben. Anschließend wurde das äußere Heizbad auf 75 °C erwärmt und die Reaktion konstant bei dieser Außentemperatur durchgeführt. Nach 2 h erfolgte die nächste Zugabe von 0,2 g AIBN [2,2'-Azobis(2-methylbutyronitril)]. Nach 4 und 8 h wurde mit jeweils 100 g Aceton/Benzin-Gemisch verdünnt. Nach 36 h Reaktionszeit wurde die Polymerisation abgebrochen und das Reaktionsgefäß auf Raumtemperatur abgekühlt.

Diese Haftklebemasse wurde an einer Streichanlage auf den Releaseliner (beidseitig silikonisiertes Glassinepapier mit abgestuftem Release) in einer Schicht von 30 µm aus Lösung beschichtet und anschließend 10 min bei 100 °C getrocknet.

Mit dem Transfertape sind eine Vielzahl von Laminierversuchen durchgeführt worden. Die dabei verwendete Grünfolie basierte auf Aluminiumoxid mit einer mittleren Korngröße von 3,5 µm und Polyvinylbutyral als Binder, Dibutylphtalat als Weichmacher und entspricht der Zusammensetzung üblicher Schlickersysteme, /88 Roo/. Aus diesem Schlicker wird eine Grünfolie über Foliengießen und Trocknen hergestellt. Die gegossene Folie ist 725 µm dick, und weist eine mittlere Porengröße von 0,6 µm auf. Für die Laminierversuche wurde die Folie zu Quadraten mit einer Kantenlänge von 30 mm geschnitten. In den Versuchen wurden Laminate aus drei Lagen hergestellt.

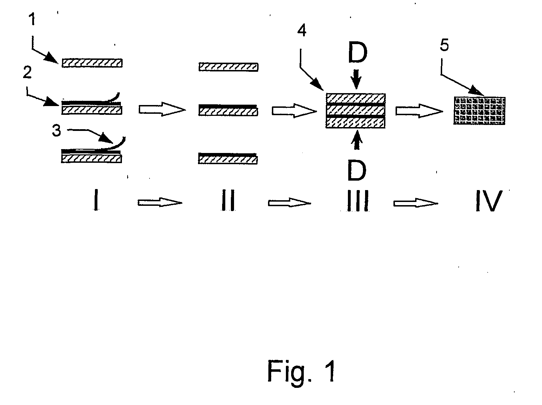

Den Laminiervorgang mit der Technik illustriert Figur 1. Folgende Verfahrensschritte sind hierbei erforderlich:

| | |
|---|---|
| I | Aufkleben des Transferklebebandes 2 |
| II | Entfernen des Silikonpapiers |
| III | Pressen |
| IV | Sintern |

Zum Laminieren wurde auf die einzelnen Grünfolienstücke 1 das Transfertape 2 aufgeklebt. Nach Abziehen des Silikonpapiers 3 wurden die einzelnen Lagen aufeinandergeschichtet und unter einem geringen Druck D miteinander zum Laminat 4 verpreßt.

Ein Laminat 4 wurde durch leichtes Andrücken der Folienlagen von Hand hergestellt. Weitere Laminate 4 wurden durch Pressen mit Drücken von 2,5 MPa und 5 MPa realisiert. Die Laminate wurden anschließend mit einem entsprechenden Ofenprogramm ausgeheizt und gesintert, so daß ein monolithischer keramischer Körper 5 entstand, in dem die Transfertapes nicht mehr vorhanden sind. Schliffe der gesinterten Laminate zeigten in allen drei Fällen keinerlei Fehler oder Nahtstellen in den Laminaten.

Entscheidend für die Wirksamkeit der neuen Technik ist ein Kleber, der für eine Fixierung der Grünfolien beim Laminieren sorgt. Die Klebemasse ist druckempfindlich, weshalb eine Verbindung schon bei geringen Anpreßdrücken möglich ist. Beim Ausheizen, d.h. bei der Temperaturerhöhung während des Brands, brennt zunächst der Binder in der Grünfolie aus. Das Polymer des Transfertapes bleibt bis ca. 250 °C stabil und bildet dann eine niederviskose Schmelze aus, deren Viskosität aufgrund von Kettenbrechung der Polymermoleküle mit zunehmender Temperatur abnimmt. Bei 300 °C konnten dynamische Viskositäten des Klebers von ca. 30 Pas gemessen werden (zum Vergleich: nach Cima /89 Cim/ zeigt Polyvinylbutyral bei 160 °C eine Viskosität von ca. 5000 Pas). Die Polymer-Schmelze wird durch Abfließen über die Poren der keramischen Schichten und durch Verdampfen kurzkettiger Crackprodukte abgebaut.

Dazu können Kleber verwendet werden, die bei dem Ausheizprozeß eine flüssige Phase in einem solchen Temperaturbereich bilden, indem die im Grünkörper verwendeten organischen Hilfsstoffe sich bereits weitestgehend zersetzt oder verflüssigt haben. Die Polymerschmelze führt in dem porösen Kapillarsystems der Grünfolie zu Kapillarkräften, die wiederum als Kapillardruck einen Sog auf die Polymerschmelze ausüben. Diese Kapillarkräfte ziehen die einzelnen Lagen der keramischen Folien zueinander. In der niederviskosen Schmelze können sich die oberflächennahen Pulverteilchen reorientieren, so daß sich bei Annäherung der einzelnen Schichten diese miteinander verzahnen und es zu einem homogenen Verbund kommt. Bei der weiteren Temperaturerhöhung führt die Verdichtung der Körper zur Eliminierung der Grenzfläche zwischen den Körpern, wodurch die Körper fest miteinander verbunden sind und die ursprünglichen Grenzflächen nicht mehr erkennbar sind.

Die im Grünkörper verwendeten organischen Hilfsstoffe sollten sich unterhalb der Verflüssigungstemperatur des Transfertapes in den jeweiligen Grünkörpern zu zersetzen oder verflüssigen beginnen, so daß diese organischen Additive bei der Verflüssigung des Transfertapes die Pulverteilchen nicht mehr fixieren, so daß sie frei beweglich sind.

Der keramische oder pulvermetallurgische Grünkörper sollte eine Porosität von >10 Vol.-% bezüglich der anorganischen Körner aufweisen und die einzelnen Pulverteilchen müssen isoliert voneinander vorliegen, d.h., es darf noch keine Sinterhalsbildung stattgefunden haben, so daß die Pulverteilchen vor dem endgültigen Ausbrand der organischen Additive noch gegeneinander verschiebbar sind.

Das Verfahren eignet sich insbesondere zum Laminieren von keramischen Grünfolien zur Herstellung von Funktions- und Ingenieurkeramiken wie zum Beispiel Gehäuse, hochintegrierten Schaltungen, Kondensatoren, Aktoren, Sensoren, HT-Brennstoffzellen, Wärmetauscher u.a. Die dabei als Zwischenprodukt hergestellten erfindungsgemäßen keramischen Grünkörper werden nach dem Verkleben mindestens einer Temperaturbehandlung unterzogen, wobei zunächst die Polymermatrix der Grünfolien zumindest weitgehend thermisch zersetzt und/oder verdunstet wird und anschließend das Transfertape zersetzt wird, und wobei anschließend der Grünkörper zu dem eigentlichen keramischen Produkt gesintert wird. Das Sintern erfolgt vorzugsweise bei Temperaturen von 700 °C bis 2000 °C.

## Patentansprüche

1. Verfahren zur Herstellung eines keramischen Grünkörpers aus mindestens zwei, miteinander verklebten, keramischen Grünkörpern, wobei
zunächst auf einen ersten keramischen Grünkörper zumindest bereichsweise und zumindest einseitig ein Transfertape aufgeklebt wird, das aus einem auf einem Releaseliner befindlichen monolithischen Klebefilm besteht,
der Releaseliner entfernt wird,
der erste keramische Grünkörper mit dem zweiten keramischen verklebt wird,
wobei der Klebefilm aus Copolymeren von Acrylaten und Methacrylaten besteht, und zwar
aus einer Mischung aus
a) Acrylsäure- und/oder Methacrylsäurederivaten entsprechend der allgemeinen Formel
CH₂=C(R₁)(COOR₂)
mit
R₁ = H oder CH₃ und
R₂ = eine verzweigte oder unverzweigte Alkylkette mit 2 bis 20 Kohlenstoffatomen, und
b) olefinisch ungesättigten Monomeren mit funktionellen Gruppen,
wobei die Komponente a) mit einem Anteil von 70 bis 99 Gew.-% und die Komponente b) mit einem Anteil von 1 bis 30 Gew.-% enthalten ist, wobei die Summe dieser Komponenten sich zu 100 Gew.-% addiert
und wobei der monolithische Klebefilm eine Schichtdicke von 2 bis 50 µm aufweist.

2. Verfahren nach Anspruch 1, **dadurch gekennzeichnet, dass** der Klebefilm eine Schichtdicke von 5 bis 25 µm aufweist.

3. Verfahren nach den Ansprüchen 1 und 2, **dadurch gekennzeichnet, dass** der Klebefilm orientiert ist.

4. Verfahren nach Anspruch 1, **dadurch gekennzeichnet, dass** als Edukte für den Klebefilm eine Mischung aus
Acrylsäure- und/oder Methacrylsäurederivaten entsprechend der allgemeinen Formel
CH₂=C(R₁)(COOR₂)
mit
R₁ = H oder CH₃ und
R₂ = eine verzweigte oder unverzweigte Alkylkette mit 2 bis 20 Kohlenstoffatomen, und
olefinisch ungesättigten Monomeren mit funktionellen Gruppen,
eingesetzt werden,
wobei die Komponente a) mit einem Anteil von 80 bis 99 Gew.-% und die Komponente b) mit einem Anteil von 1 bis 20 Gew.-% enthalten ist, wobei die Summe dieser Komponenten sich zu 100 Gew.-% addiert.

5. Verfahren nach Anspruch 1, **dadurch gekennzeichnet, dass** die Grünkörper nach Aufbringen des Transfertapes und Abziehen des Releaseliners durch insbesondere leichten Andruck miteinander verklebt werden.

6. Verfahren zur Herstellung eines keramischen Grünkörpers nach zumindest einem der vorherigen Ansprüche, **dadurch gekennzeichnet, dass** die keramischen Grünkörper aus keramischen Grünfolien mit mindestens zwei miteinander verklebten, keramischen Grünfolien hergestellt werden, wobei die Grünfolien unmetallisiert oder metallisiert sein können.

7. Verfahren zur Herstellung eines keramischen Grünkörpers nach zumindest einem der vorherigen Ansprüche, **dadurch gekennzeichnet, dass** die Verarbeitung kontinuierlich von Rollen erfolgt.

8. Verwendung von keramischen Grünkörpern nach zumindest einem der vorherigen Ansprüche zur Sinterung von Keramiken.

9. Verwendung von keramischen Grünkörpern nach Anspruch 8, **dadurch gekennzeichnet, dass** der keramische Grünkörper nach dem Verkleben mindestens einer Temperaturbehandlung unterzogen wird, wobei zunächst die Polymermatrix der Grünfolien zumindest weitgehend thermisch zersetzt und/oder verdunstet wird, anschließend der Klebefilm zersetzt wird und wobei anschließend der Grünkörper zu dem eigentlichen keramischen Produkt gesintert wird.

10. Verwendung nach Anspruch 9, **dadurch gekennzeichnet, dass** das Sintern bei Temperaturen von 700 °C bis 2000 °C erfolgt.

## Claims

1. Method of producing a green ceramic body comprising at least two green ceramic bodies adhesively bonded to one another, where a transfer tape comprising a monolithic film of adhesive on a release liner is firstly applied to a first green ceramic body, at least in regions and at least on one side,
the release liner is removed and
the first green ceramic body is adhesively bonded to the second ceramic body, with
the adhesive film comprising copolymers of acrylates and methacrylates, and specifically a mixture of
a) derivatives of acrylic acid and/or methacrylic acid corresponding to the formula
CH₂=C(R₁)(COOR₂)
where
R₁ = H or CH₃ and
R₂ = a branched or unbranched alkyl chain having from 2 to 20 carbon atoms and
b) olefinically unsaturated monomers having functional groups,
where the component a) is present in an amount of from 70 to 99% by weight and the component b) is present in an amount of from 1 to 30% by weight, where the sum of these components is 100% by weight
and the monolithic adhesive film has a thickness of from 2 to 50 µm.

2. Method according to Claim 1, **characterized in that** the adhesive film has a thickness of from 5 to 25 µm.

3. Method according to Claim 1 or 2, **characterized in that** the adhesive film is oriented.

4. Method according to Claim 1, **characterized in that** a mixture of
derivatives of acrylic acid and/or methacrylic acid corresponding to the formula
CH₂=C(R₁)(COOR₂)
where
R₁ = H or CH₃ and
R₂ = a branched or unbranched alkyl chain having from 2 to 20 carbon atoms, and
olefinically unsaturated monomers having functional groups,
is used as starting material for the adhesive film,
where the component a) is present in an amount of from 80 to 99% by weight and the component b) is present in an amount of from 1 to 20% by weight, where the sum of these components is 100% by weight.

5. Method according to Claim 1, **characterized in that** after application of the transfer tape and removal of the release liner, the green bodies are adhesively bonded to one another by means of, in particular, light pressure.

6. Method of producing a green ceramic body according to at least one of the preceding claims, **characterized in that** the green ceramic bodies are produced from green ceramic sheets with at least two green ceramic sheets adhesively bonded to one another, with the green sheets being able to be unmetallized or metallized.

7. Method of producing a green ceramic body according to at least one of the preceding claims, **characterized in that** processing is carried out continuously from rolls.

8. Use of green ceramic bodies according to at least one of the preceding claims for sintering of ceramics.

9. Use of green ceramic bodies according to Claim 8, **characterized in that** the green ceramic body after adhesive bonding is subjected to at least one heat treatment during which the polymer matrix of the green sheets is firstly at least largely thermally decomposed and/or vaporized, the adhesive film is subsequently decomposed and the green body is then sintered to form the actual ceramic product.

10. Use according to Claim 9, **characterized in that** sintering is carried out at temperatures of from 700°C to 2000°C.

## Revendications

1. Procédé pour la préparation d'un corps cru céramique composé d'au moins deux corps crus céramiques assemblés l'un à l'autre par collage, une bande de transfert, composée d'un film adhésif monolithique se trouvant sur une feuille antiadhésive, étant d'abord collée sur un premier corps cru céramique, au moins en partie et au moins d'un côté, la feuille antiadhésive étant enlevée, le premier corps cru céramique étant assemblé par collage avec le deuxième corps céramique, le film adhésif étant constitué par des copolymères d'acrylates et de méthacrylates, en fait d'un mélange de
a) dérivés d'acide acrylique et/ou d'acide méthacrylique de formule générale
CH₂=C(R₁)(COOR₂)
avec
R₁ = H ou CH₃ et
R₂ = une chaîne alkyle linéaire ou ramifiée comprenant 2 à 20 atomes de carbone, et
b) monomères oléfiniquement insaturés présentant des groupes fonctionnels,
le composant a) étant contenu en une proportion de 70 à 99% en poids et le composant b) en une proportion de 1 à 30% en poids, la somme de ces composants s'ajoutant 100% en poids, et
le film adhésif monolithique présentant une épaisseur de couche de 2 à 50 µm.

2. Procédé selon la revendication 1, **caractérisé en ce que** le film adhésif présente une épaisseur de couche de 5 à 25 µm.

3. Procédé selon les revendications 1 et 2, **caractérisé en ce que** le film adhésif est orienté.

4. Procédé selon la revendication 1, **caractérisé en ce qu'**on utilise comme produits de départ pour le film adhésif un mélange de dérivés d'acide acrylique et/ou d'acide méthacrylique de formule générale
CH₂=C(R₁)(COOR₂)
avec
R₁ = H ou CH₃ et
R₂ = une chaîne alkyle linéaire ou ramifiée comprenant 2 à 20 atomes de carbone, et
des monomères oléfiniquement insaturés avec des groupes fonctionnels,
le composant a) étant contenu en une proportion de 80 à 99% en poids et le composant b) en une proportion de 1 à 20% en poids, la somme de ces composants s'ajoutant jusqu'à 100% en poids.

5. Procédé selon la revendication 1, **caractérisé en ce que** les corps crus sont assemblés par collage l'un à l'autre après l'application de la bande de transfert et l'élimination du film antiadhésif par une pression particulièrement légère.

6. Procédé pour la préparation d'un corps cru céramique selon au moins l'une quelconque des revendications précédentes, **caractérisé en ce que** les corps crus céramiques sont préparés à partir de feuilles crues céramiques présentant au moins deux feuilles crues céramiques assemblées par collage l'une à l'autre, les feuilles crues pouvant être non métallisées ou métallisées.

7. Procédé pour la préparation d'un corps cru céramique selon au moins l'une quelconque des revendications précédentes, **caractérisé en ce que** la transformation a lieu en continu à partir de rouleaux.

8. Utilisation de corps crus céramiques selon au moins l'une quelconque des revendications précédentes pour le frittage de céramiques.

9. Utilisation de corps crus céramiques selon la revendication 8, **caractérisée en ce que** le corps cru céramique est soumis, après le collage, à au moins un traitement thermique, la matrice polymère des feuilles crues étant d'abord au moins dans une large mesure décomposée et/ou volatilisée thermiquement, ensuite le film adhésif est décomposé et le corps cru étant ensuite fritté en produit céramique en soi.

10. Utilisation selon la revendication 9, **caractérisée en ce que** le frittage a lieu à des températures de 700°C à 2000°C.
